# EUROPEAN PATENT SPECIFICATION

(11) **EP 2 870 743 B1**
(45) Date of publication and mention of the grant of the patent: **14.09.2016**
(21) Application number: 12735273.0
(22) Date of filing: 09.07.2012
(51) Int. Cl.: H04M 1/18, H04W 52/02, H05K 5/02

(54) **MOISTURE REDUCTION IN AN ELECTRIC ASSEMBLY**
FEUCHTIGKEITSVERMINDERUNG IN EINER ELEKTRISCHEN ANLAGE
DIMINUTION DU NIVEAU D'HUMIDITÉ DANS UN ENSEMBLE ÉLECTRIQUE

(43) Date of publication of application: 13.05.2015
(73) Proprietor: Telefonaktiebolaget LM Ericsson (publ), 164 83 Stockholm (SE)
(72) Inventor: SNYGG, Göran, SE-433 43 Partille (SE); SJÖBERG, Daniel, SE-431 49 Mölndal (SE)
(74) Representative: Ericsson
(86) International application number: PCT/EP2012/063406
(87) International publication number: WO 2014/008916

(56) References cited:
- EP-A1- 1 988 536
- US-A1- 2001 045 421
- US-A1- 2005 079 888

## Description

### TECHNICAL FIELD

The present invention relates to an electric assembly comprising at least two semiconductor components The electric assembly is arranged to be switched between a first mode and a second mode. The electric assembly is arranged to be run in a stand-by condition during the first mode and in an operational condition during the second mode.

The present invention also relates to a method for heating an electric assembly in order to reduce moisture in the electric assembly. The method comprises the step of switching between a first mode and a second mode, the second mode being associated with an operational condition.

### BACKGROUND

Modern electronic equipment is more and more focused on saving energy and it is therefore desirable to run different electric applications in so called power saving modes or stand-by modes.

Components that are designed to work in modes with relatively high power consumption are in general not tested, or designed for, high reliability when run at a reduced power consumption, for example during power saving modes or stand-by modes. It is often assumed that lower component temperatures imply increased component lifetime. However, this is not the case when lower temperatures increase the risk of damp intrusion in the component. This effect may lead to a failure of the component in a very short time.

Component failure mechanisms are not the same for a component that is exposed to damp environment as for a component that is exposed to excessive heat. Moist causes corrosion, while heat may cause the gate of the device to sink down in the semiconductor. For equipment used in a damp environment, power saving modes may cause a very rapid failure. Experience shows that equipment is subject to failure much earlier in damp regions compared to hot and dry regions. In a damp region, this problem occurs for electronic equipment outside as well as inside.

During normal operation, each component is self-heated by its power consumption, and no moist can be absorbed, while at the same time previously collected moisture is removed. This is however not the case during power stand-by. In a stand-by mode, amplifier components such as transistors often choked by setting a high drain voltage in combination with a high negative gate voltage, thus reducing the drain current, a so-called pinch off mode. This will lead to a high potential difference over the transistor, which will attract moisture even more, and also accelerate corrosion phenomena.

At the same time as the component is exposed to corrosion effects due to the bias, there is no self-heating function that removes the moisture. A further factor that contributes to the moisture gathering is that those components that are most suitable for power saving are the components that have the highest power consumption during normal operation. These components are thus often placed to acquire sufficient cooling, but in a stand-by mode, cooling will only contribute to the moisture collection.

Existing solutions that are used to handle moisture are hermetically sealed packages and demoisturisers.

Hermetical sealed designs will prevent moisture to get inside components, but a major drawback of this solution is that it significantly reduces the amount of potential components on the market, and also increases the component cost dramatically. Demoisturisers are large in size and also have limited lifetime. Therefore they would need to be serviced, with corresponding high service costs. Another way of handling moisture is to use silicate absorbers, but these are made for single use and will relatively soon cease to function.

US2001045421 discloses a device that has a heat-generating source that is inserted into an electrical device to be protected from the formation of condensation. Power may be supplied manually or automatically.

EP 1 988 536 discloses an image display device having a psuedo a stand by mode in which backlight is maintained to heat the device and thereby reduce condensation. There still exists a problem regarding moisture that forms on electric equipment that at least from time to time is run in a stand-by mode where the environment is damp. It is therefore desired to obtain an inexpensive and uncomplicated way to reduce formation of moisture at such electric equipment.

### SUMMARY

It is an object of the present invention to provide a device and a method for reducing formation of moisture at electric equipment that at least from time to time is run at a stand-by mode. This should be accomplished in an inexpensive and uncomplicated way.

This object is obtained by means of an electric assembly comprising at least two semiconductor components The electric assembly is arranged to be switched between a first mode and a second mode. The electric assembly is arranged to be run in a stand-by condition during the first mode and in an operational condition during the second mode. The electric assembly is arranged to be switched between a stand-by condition and a heating condition during the first mode. At least two semiconductor components being run sequentially during the heating condition such that an amount of heat is generated.

This object is also obtained by means of a method for heating an electric assembly in order to reduce moisture in the electric assembly. The method comprises the step of switching between a first mode and a second mode, the second mode being associated with an operational condition. The method further comprises the steps of, during the first mode, switching between a stand-by condition and a heating condition; and during the heating condition, supplying power to at least two semiconductor components sequentially such that an amount of heat is generated.

According to an example, the electric assembly comprises a radio transmitter and at least one antenna output arranged to be connected to at least one antenna. The radio transmitter in turn comprises at least one semiconductor component in the form of a first amplifying unit which at least partly is arranged to be run during the heating condition.

According to another example, all amplifying units comprised in the electric assembly may be run at the same time during the heating condition. Alternatively, at least two amplifying units may be run sequentially during the heating condition.

According to another example, the first amplifying unit comprises a plurality of amplifying sub-units. All amplifying sub-units may be run at the same time during the heating condition. Alternatively, at least two amplifying sub-units may be run sequentially during the heating condition.

According to another example, a control unit is arranged to switch between the first mode and the second mode, as well as between the stand-by condition and the heating condition.

The present invention also relates to a node in a wireless communication system comprising an electric assembly according to the above.

Other examples are disclosed in the dependent claims.

A number of advantages are provided by means of the present invention. For example:
- moisture is removed before it can cause any harm such that good reliability is achieved even in damp environments where moisture normally will cause a lot of problems;
- it is very inexpensive and easily implemented by software, adding no new components; and
- in addition to implementing it in new systems, it can also be applied in field to existing electric assemblies already delivered, thus improving the lifetime of electric assemblies already on the market.

### BRIEF DESCRIPTION OF THE DRAWINGS

The present invention will now be described more in detail with reference to the appended drawings, where:
- Figure 1: schematically shows a node in a wireless communications system;
- Figure 2: schematically shows an electric assembly;
- Figure 3: schematically shows an amplifying unit;
- Figure 4: schematically shows the schematics of a transistor; and
- Figure 5: schematically shows a flow chart for a method according to the present invention.

### DETAILED DESCRIPTION

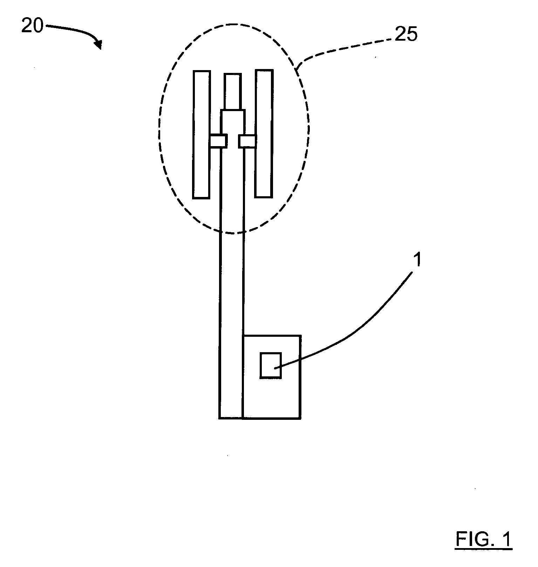

Figure 1 schematically shows a node 20 in a wireless communication system, the node 20 comprising a radio unit 1 and an antenna arrangement 25.

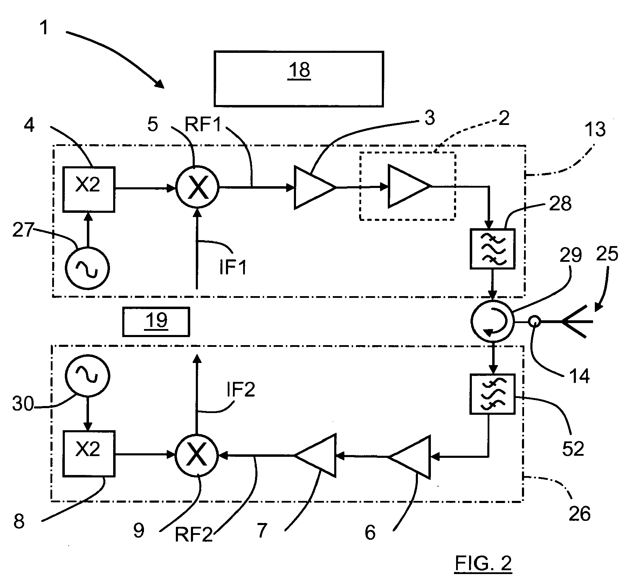

Figure 2 schematically shows the radio unit 1 which comprises a radio transmitter 13, a radio receiver 26 and an antenna output 14 arranged to be connected to the antenna arrangement 25. The radio transmitter comprises a first oscillator 27 connected to a first frequency multiplier 4 and a first signal multiplier 5. The first signal multiplier 5 combines the frequency multiplied oscillator signal with a first intermediate frequency signal IF1, the first intermediate frequency signal IF1 comprising the information that is going to be transmitted.

The up-converted output from the first signal multiplier 5 constitutes a first radio frequency signal RF1 which is fed into a first amplifying unit 2 via a second amplifying unit 3, the first amplifying unit 2 constituting a main amplifying stage. The amplified first radio frequency signal RF1 signal is fed through a first filter 28, a directional coupler 29 and to the antenna arrangement 25 via an antenna output port.

In the same way, the receiver 26 comprises a second oscillator 30 connected to a second frequency multiplier 8 and a second signal multiplier 9. A received signal is fed via the antenna port 14 and the directional coupler 29 to a third amplifying unit 7 and a fourth amplifying unit 7 via a second filter 52. The amplified signal constitutes a second radio frequency signal RF2 which is down-converted in the second signal multiplier 9, the output being a second intermediate frequency signal IF2 comprising the information that has been received.

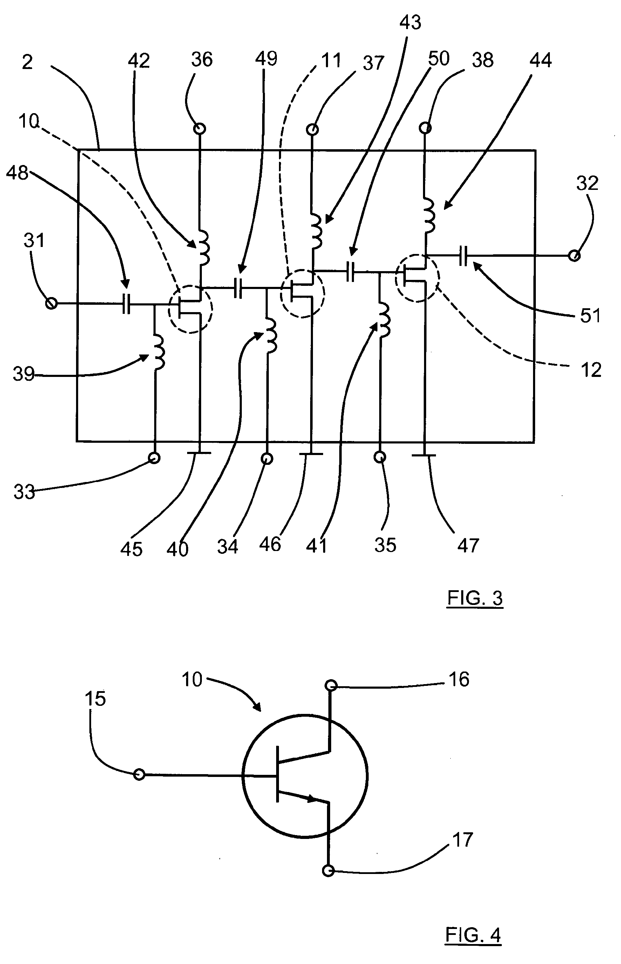

Figure 3 shows the first amplifying unit 2 more in detail, although the schematics still is simplified and only is intended to confer a general understanding. The first amplifying unit 2 has a signal input 31 and a signal output 32. An input signal is fed into the signal input 31, via a first transistor 10, a second transistor 11 and a third transistor 12 and further to the signal output 32. A detail of the first transistor 10 is shown in Figure 4, the first transistor 10 having a gate 15, a source 16 and a drain 17, which all constitute transistor ports. The transistors 10, 11, 12 have a common general configuration, but may vary regarding gain and power handling.

Each transistor 10, 11, 12 in Figure 2 is individually biased via corresponding gate bias ports 33, 34, 35 and source bias ports 36, 37, 38. Each bias port 33, 34, 35; 36, 37, 38 is connected to a respective transistor port 15, 16 via a corresponding high frequency blocking inductance 39, 40, 41; 42, 43, 44. The transistor drain 17 of each transistor 10, 11, 12 is connected to a respective ground connection 45, 46, 47. Furthermore, in the signal path, between the signal input 31 and the first transistor 10, between the transistors 10, 11, 12 and between the third transistor 12 and the signal output 32, there are bias current blocking capacitors 48, 49, 50, 51.

As indicated previously, the above description of the first amplifying unit 2 is of course simplified, and should be regarded as a general example of how an amplifying unit 2 may be designed, which also is well-known in the art. All amplifying units 2, 3; 6, 7 may have a similar design, with varying numbers and models of transistors.

The bias ports 33, 34, 35; 36, 37, 38 are controlled by a control unit 18, the control unit 18 being connected to and controlling the semiconductor components 2, 3, 4, 5; 6, 7, 8, 9; 10, 11 of the radio unit 1. The control unit 18 is arranged to switch the radio unit 1 between a first mode and a second mode, where the radio unit 1 is arranged to be run in a stand-by condition during the first mode and where the radio unit 1 is arranged to be run in an operational condition during the second mode. In the operational condition, the radio unit 1 is transmitting and receiving information, possibly at different power levels in dependence of traffic load. During the stand-by condition, the radio unit is not transmitting and/or receiving any signals via the respective transmitter 13 and receiver 26. During the stand-by condition, the bias may be absent or kept at a low level. Generally, in this context, a stand-by condition means that an electric assembly is supplied with no power, or such a low amount of power that it is not able to perform its normal function or functions.

According to the present invention, the control unit 18 is arranged to switch the radio unit 1 between a stand-by condition and a heating condition during the first mode, at least two semiconductor components 2, 3, 4, 5; 6, 7, 8, 9; 10, 11, 12 being run during the heating condition such that an amount of heat is generated. By means of this heat, moisture in the radio unit 1 is reduced.

In this example, the amplifying units 2, 3; 6, 7 are the most power-consuming and heat-generating parts in the radio unit 1, where the first amplifying unit 2 that is part of the transmitter 13 is the most power-consuming and heat-generating of them all. Therefore, during the first mode where the radio unit 1 is at a stand-by state in order to save power, the control unit 18 has choked bias voltage to the amplifying units 2, 3; 6, 7 such that they have assumed a pinch-off mode as described initially. At certain times, however, the control unit 18 is arranged to allow supply bias voltage to the amplifying units 2, 3; 6, 7, one at a time, switching from stand-by condition to heating condition. By supplying bias voltage to the amplifying units 2, 3; 6, 7 one at a time, no transmitting or receiving functionality is incurred during the heating condition. It is conceivable that also the single transistors 10, 11, 12 in the amplifying units 2, 3; 6, 7 are biased one at a time. At least two amplifying units 2, 3; 6, 7 and/or, at least two transistors 10, 11, 12 is biased sequentially.

Furthermore, other semiconductors in the radio unit 1 such as the frequency multipliers 4, 8 and the signal multipliers 5, 9 may also be run during the heating condition, and in they may also be run at the same time or sequentially or at the same time, alone or in combination with one or more amplifying unit 2, 3; 6, 7.

Combinations and variations of the above is also conceivable, for example irregular patterns for the heating condition cycles.

The basic principle is thus to cycle the bias between a stand-by condition and a heating condition. The heating condition comprises all conditions from biasing at least two semiconductor components 2, 3, 4, 5; 6, 7, 8, 9; 10, 11, 12 such that an amount of heat is produced to running the entire radio unit, or combinations of this. The control unit 18 is therefore arranged to either bias one semiconductor component 2, 3, 4, 5; 6, 7, 8, 9; 10, 11, 12 at a time, or to run all semiconductor components 2, 3, 4, 5; 6, 7, 8, 9; 10, 11, 12 at the same time, or combinations thereof.

This would lead to that moisture is removed before it can cause any harm. It is possible to use existing and relatively cheap components to achieve good reliability even in damp environments where moisture normally will cause a lot of problems. This is easily achieved by software modification and could either be triggered by one or more moisture sensors 19, as shown n Figure 2, and/or periodically.

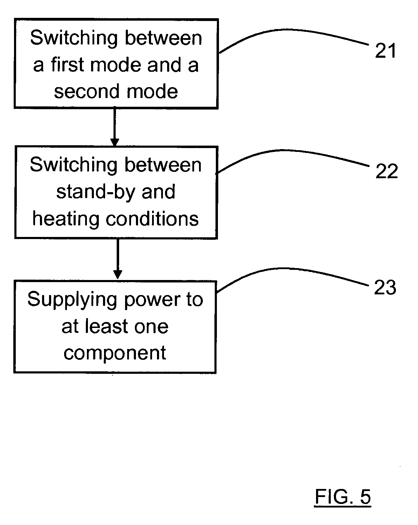

With reference to Figure 5, the present invention also relates to a method for heating an electric assembly in order to reduce moisture in the electric assembly 1, where method comprises the steps:
21: switching between a first mode and a second mode, the second mode being associated with an operational condition;
22: during the first mode, switching between a stand-by condition and a heating condition; and
23: during the heating condition, supplying power to at least one semiconductor component 2, 3, 4, 5; 6, 7, 8, 9; 10, 11, 12 such that an amount of heat is generated.

The present invention is not limited to the examples above, but may vary freely within the scope of the appended claims. For example, the present invention is not limited to radio units of the types described, but may generally be used for any type of radio unit, and furthermore in general for any type of electric assembly, for example other types of transmitters and receivers as well as for vehicle control units and home electronics such as television sets and burglar alarms which comprise a number of parts or other indoor or outdoor electric and/or electronic equipment that may run in a stand-by mode. Other examples are mobile phones and computers. Generally, all these constitute electrical assemblies.

It is conceivable that the heating condition corresponds to the second mode where the electric assembly is run in an operational condition. However, switching on/off one component at a time is preferred where it is desired that no signal energy is allowed to be sent out. This may be the case for a redundancy radio unit, where a complete radio unit may be connected in parallel with a normally running radio unit. The redundancy radio unit is kept at stand-by until the normally running radio unit fails, and the redundancy radio is then switched on such that radio services are not interrupted. Such a redundancy radio unit may be kept at stand-by condition for many years, but when it is about to be committed, it is important that it works. In this case, the present invention confers a high level of reliability for such a redundancy radio unit.

The transistors described may be of any suitable kind and number, and generally constitute amplifying sub-units 10, 11, 12.

The control unit 18 may at least partly be a part of the radio unit, and may also at least partly be comprised in an external control system. The present invention may be controlled by any type of control unit 18 as well as by any other suitable device, for example by a clock.

## Claims

1. An electric assembly (1) comprising at least two semiconductor components (2, 3, 4, 5; 6, 7, 8, 9; 10, 11, 12), the electric assembly (1) being arranged to be switched between a first mode and a second mode, where the electric assembly (1) is arranged to be run in a stand-by condition during the first mode and where the electric assembly is arranged to be run in an operational condition during the second mode, **characterized in that** the electric assembly (1) is arranged to be switched between a stand-by condition and a heating condition during the first mode, the at least two semiconductor components (2, 3, 4, 5; 6, 7, 8, 9; 10, 11, 12) being run sequentially during the heating condition such that an amount of heat is generated.

2. An electric assembly according to claim 1, **characterized in that** the electric assembly (1) comprises a radio transmitter (13) and at least one antenna output (14) arranged to be connected to at least one antenna (25), the radio transmitter (13) in turn comprising at least one semiconductor component in the form of a first amplifying unit (2), which first amplifying unit (2) at least partly is arranged to be run during the heating condition.

3. An electric assembly according to claims 2, **characterized in that** at least two amplifying units (2, 3; 6, 7) comprised in the electric assembly (1) are run sequentially during the heating condition.

4. An electric assembly according to any one of the claims 2 or 3, **characterized in that** said first amplifying unit (2) comprises a plurality of amplifying sub-units (10, 11, 12), all amplifying sub-units (10, 11, 12) being run at the same time during the heating condition.

5. An electric assembly according to any one of the claims 2 or 3, **characterized in that** said first amplifying unit (2) comprises a plurality of amplifying sub-units (10, 11, 12), at least two amplifying sub-units (10, 11, 12) being run sequentially during the heating condition.

6. An electric assembly according to any one of the claims 4 or 5, **characterized in that** each amplifying sub-unit is in the form of a transistor (10, 11, 12).

7. An electric assembly according to any one of the previous claims, **characterized in that** a control unit (18) is arranged to switch between the stand-by condition and the heating condition.

8. An electric assembly according to claim 7, **characterized in that** the control unit (18) is arranged to switch between the stand-by condition and the heating condition in dependence of predetermined time periods and/or input from at least one moisture sensor (19) comprised in the electric assembly (1) and/or instructions from an operator.

9. A node (20) in a wireless communication system comprising an electric assembly (1) according to any one of the claims 1-8.

10. A method for heating an electric assembly in order to reduce moisture in the electric assembly (1), where the method comprises the step:
(21) switching between a first mode and a second mode, the second mode being associated with an operational condition;
**characterized in that** the method further comprises the steps:
(22) during the first mode, switching between a stand-by condition and a heating condition; and
(23) during the heating condition, supplying power to at least two semiconductor components (2, 3, 4, 5; 6, 7, 8, 9; 10, 11, 12) sequentially such that an amount of heat is generated.

11. A method according to claim 10, **characterized in that** at least one semiconductor component (2, 3, 4, 5; 6, 7, 8, 9; 10, 11, 12) is in the form of an amplifying unit (2, 3; 6, 7), where the method comprises the step of at least partly running at least a first amplifying unit (2) during the heating condition.

12. A method according to claim 11, **characterized in that** the method comprises running at least two amplifying units (2, 3; 6, 7) sequentially during the heating condition.

13. A method according to any one of the claims 11 or 12 **characterized in that** at least said first amplifying unit (2) uses a plurality of amplifying sub-units (10, 11, 12), where the method comprises running all amplifying sub-units (10, 11, 12) at the same time during the heating condition.

14. A method according to any one of the claims 11 or 12 **characterized in that** at least said first amplifying unit (2) uses a plurality of amplifying sub-units (10, 11, 12), where the method comprises running at least two amplifying sub-units (10, 11, 12) sequentially during the heating condition.

## Patentansprüche

1. Elektrische Baugruppe (1), die mindestens zwei Halbleiterkomponenten (2, 3, 4, 5; 6, 7, 8, 9; 10, 11, 12) umfasst, wobei die elektrische Baugruppe (1) dafür eingerichtet ist, zwischen einem ersten Modus und einem zweiten Modus umgeschaltet zu werden, worin die elektrische Baugruppe (1) dafür eingerichtet ist, während des ersten Modus in einem Bereitschaftszustand betrieben zu werden, und worin die elektrische Baugruppe dafür eingerichtet ist, während des zweiten Modus in einem Betriebszustand betrieben zu werden, **dadurch gekennzeichnet, dass** die elektrische Baugruppe (1) dafür eingerichtet ist, während des ersten Modus zwischen einem Bereitschaftszustand und einem Heizzustand umgeschaltet zu werden, wobei die mindestens zwei Halbleiterkomponenten (2, 3, 4, 5; 6, 7, 8, 9; 10, 11, 12) während des Heizzustandes der Reihe nach betrieben werden, sodass ein Betrag von Wärme erzeugt wird.

2. Elektrische Baugruppe nach Anspruch 1, **dadurch gekennzeichnet, dass** die elektrische Baugruppe (1) einen Funksender (13) und mindestens einen Antennenausgang (14) umfasst, der dafür eingerichtet ist, mit mindestens einer Antenne (25) verbunden zu werden, wobei der Funksender (13) wiederum mindestens eine Halbleiterkomponente in Form einer ersten Verstärkungseinheit (2) umfasst, wobei diese erste Verstärkungseinheit (2) zumindest teilweise dafür eingerichtet ist, während des Heizzustandes betrieben zu werden.

3. Elektrische Baugruppe nach Anspruch 2, **dadurch gekennzeichnet, dass** mindestens zwei in die elektrische Baugruppe (1) einbezogene Verstärkungseinheiten (2, 3; 6, 7) während des Heizzustandes der Reihe nach betrieben werden.

4. Elektrische Baugruppe nach einem der Ansprüche 2 oder 3, **dadurch gekennzeichnet, dass** die erste Verstärkungseinheit (2) eine Vielzahl von Verstärkungsuntereinheiten (10, 11, 12) umfasst, wobei alle Verstärkungsuntereinheiten (10, 11, 12) während des Heizzustandes zur gleichen Zeit betrieben werden.

5. Elektrische Baugruppe nach einem der Ansprüche 2 oder 3, **dadurch gekennzeichnet, dass** die erste Verstärkungseinheit (2) eine Vielzahl von Verstärkungsuntereinheiten (10, 11, 12) umfasst, wobei mindestens zwei Verstärkungsuntereinheiten (10, 11, 12) während des Heizzustandes der Reihe nach betrieben werden.

6. Elektrische Baugruppe nach einem der Ansprüche 4 oder 5, **dadurch gekennzeichnet, dass** jede Verstärkungsuntereinheit in Form eines Transistors (10, 11, 12) vorliegt.

7. Elektrische Baugruppe nach einem der vorhergehenden Ansprüche, **dadurch gekennzeichnet, dass** eine Steuerungseinheit (18) dafür eingerichtet ist, zwischen dem Bereitschaftszustand und dem Heizzustand umzuschalten.

8. Elektrische Baugruppe nach Anspruch 7, **dadurch gekennzeichnet, dass** die Steuerungseinheit (18) dafür eingerichtet ist, zwischen dem Bereitschaftszustand und dem Heizzustand in Abhängigkeit von vorbestimmten Zeitabschnitten und/oder einer Eingabe von mindestens einem in die elektrische Baugruppe (1) einbezogenen Feuchtigkeitssensor (19) und/oder Anweisungen von einem Bediener umzuschalten.

9. Knoten (20) in einem drahtlosen Kommunikationssystem, der eine elektrische Baugruppe (1) nach einem der Ansprüche 1 bis 8 umfasst.

10. Verfahren zum Heizen einer elektrischen Baugruppe, um Feuchtigkeit in der elektrischen Baugruppe (1) zu verringern, worin das Verfahren den Schritt umfasst:
(21) Umschalten zwischen einem ersten Modus und einem zweiten Modus, wobei der zweite Modus mit einem Betriebszustand assoziiert ist;
**dadurch gekennzeichnet, dass** das Verfahren ferner die Schritte umfasst:
(22) während des ersten Modus: Umschalten zwischen einem Bereitschaftszustand und einem Heizzustand; und
(23) während des Heizzustandes: der Reihe nach erfolgendes Zuführen von Leistung zu mindestens zwei Halbleiterkomponenten (2, 3, 4, 5; 6, 7, 8, 9; 10, 11, 12), sodass ein Betrag von Wärme erzeugt wird.

11. Verfahren nach Anspruch 10, **dadurch gekennzeichnet, dass** mindestens eine Halbleiterkomponente (2, 3, 4, 5; 6, 7, 8, 9; 10, 11, 12) in Form einer Verstärkungseinheit (2, 3; 6, 7) vorliegt, worin das Verfahren den Schritt umfasst: zumindest teilweises Betreiben mindestens einer ersten Verstärkungseinheit (2) während des Heizzustandes.

12. Verfahren nach Anspruch 11, **dadurch gekennzeichnet, dass** das Verfahren den Schritt umfasst: der Reihe nach erfolgendes Betreiben von mindestens zwei Verstärkungseinheiten (2, 3; 6, 7) während des Heizzustandes.

13. Verfahren nach einem der Ansprüche 11 oder 12, **dadurch gekennzeichnet, dass** mindestens die erste Verstärkungseinheit (2) eine Vielzahl von Verstärkungsuntereinheiten (10, 11, 12) verwendet, worin das Verfahren umfasst: zur gleichen Zeit erfolgendes Betreiben aller Verstärkungsuntereinheiten (10, 11, 12) während des Heizzustandes.

14. Verfahren nach einem der Ansprüche 11 oder 12, **dadurch gekennzeichnet, dass** mindestens die erste Verstärkungseinheit (2) eine Vielzahl von Verstärkungsuntereinheiten (10, 11, 12) verwendet, worin das Verfahren umfasst: der Reihe nach erfolgendes Betreiben von mindestens zwei Verstärkungsuntereinheiten (10, 11, 12) während des Heizzustandes.

## Revendications

1. Ensemble électrique (1) comprenant au moins deux composants semi-conducteurs (2, 3, 4, 5 ; 6, 7, 8, 9; 10, 11, 12), l'ensemble électrique (1) étant agencé pour être commuté entre un premier mode et un deuxième mode, où l'ensemble électrique (1) est agencé pour être mis en fonctionnement dans une condition d'attente dans le premier mode et où l'ensemble électrique est agencé pour être mis en fonctionnement dans une condition de fonctionnement dans le deuxième mode, **caractérisé en ce que** l'ensemble électrique (1) est agencé pour être commuté entre une condition d'attente et une condition de chauffage dans le premier mode, lesdits au moins deux composants semi-conducteurs (2, 3, 4, 5; 6, 7, 8, 9; 10, 11, 12) étant mis en fonctionnement séquentiellement pendant la condition de chauffage de sorte qu'une quantité de chaleur soit générée.

2. Ensemble électrique selon la revendication 1, **caractérisé en ce que** l'ensemble électrique (1) comprend un émetteur radio (13) et au moins une sortie d'antenne (14) agencée pour être connectée à au moins une antenne (25), l'émetteur radio (13) comprenant à son tour au moins un composant semi-conducteur sous la forme d'une première unité d'amplification (2), laquelle première unité d'amplification (2) est agencée au moins partiellement pour être mise en fonctionnement pendant la condition de chauffage.

3. Ensemble électrique selon la revendication 2, **caractérisé en ce qu'**au moins deux unités d'amplification (2, 3; 6, 7) comprises dans l'ensemble électrique (1) sont mises en fonctionnement séquentiellement pendant la condition de chauffage.

4. Ensemble électrique selon l'une quelconque des revendications 2 ou 3, **caractérisé en ce que** ladite première unité d'amplification (2) comprend une pluralité d'unités d'amplification secondaires (10, 11, 12), toutes les unités d'amplification secondaires (10, 11, 12) étant mises en fonctionnement simultanément pendant la condition de chauffage.

5. Ensemble électrique selon l'une quelconque des revendications 2 ou 3, **caractérisé en ce que** ladite première unité d'amplification (2) comprend une pluralité d'unités d'amplification secondaires (10, 11, 12), au moins deux unités d'amplification secondaires (10, 11, 12) étant mises en fonctionnement séquentiellement pendant la condition de chauffage.

6. Ensemble électrique selon l'une quelconque des revendications 4 ou 5, **caractérisé en ce que** chaque unité d'amplification secondaire est sous la forme d'un transistor (10, 11, 12).

7. Ensemble électrique selon l'une quelconque des revendications précédentes, **caractérisé en ce qu'**une unité de commande (18) est agencée pour commuter entre la condition d'attente et la condition de chauffage.

8. Ensemble électrique selon la revendication 7, **caractérisé en ce que** l'unité de commande (18) est agencée pour commuter entre la condition d'attente et la condition de chauffage en fonction de périodes de temps prédéterminées et/ou d'une entrée provenant d'au moins un capteur d'humidité (19) compris dans l'ensemble électrique (1) et/ou d'instructions provenant d'un opérateur.

9. Noeud (20) dans un système de communication sans fil comprenant un ensemble électrique (1) selon l'une quelconque des revendications 1 à 8.

10. Procédé pour chauffer un ensemble électrique afin de réduire l'humidité dans l'ensemble électrique (1), où le procédé comprend l'étape :
(21) de commutation entre un premier mode et un deuxième mode, le deuxième mode étant associé à une condition de fonctionnement ;
**caractérisé en ce que** le procédé comprend en outre les étapes :
(22) dans le premier mode, de commutation entre une condition d'attente et une condition de chauffage ; et
(23) pendant la condition de chauffage, d'alimentation d'au moins deux composants semi-conducteurs (2, 3, 4, 5; 6, 7, 8, 9; 10, 11, 12) séquentiellement de sorte qu'une quantité de chaleur soit générée.

11. Procédé selon la revendication 10, **caractérisé en ce qu'**au moins un composant semi-conducteur (2, 3, 4, 5; 6, 7, 8, 9; 10, 11, 12) est sous la forme d'une unité d'amplification (2, 3; 6, 7), où le procédé comprend l'étape de mise en fonctionnement au moins partiellement d'au moins une première unité d'amplification (2) pendant la condition de chauffage.

12. Procédé selon la revendication 11, **caractérisé en ce que** le procédé comprend la mise en fonctionnement d'au moins deux unités d'amplification (2, 3; 6, 7) séquentiellement pendant la condition de chauffage.

13. Procédé selon l'une quelconque des revendications 11 ou 12, **caractérisé en ce qu'**au moins ladite première unité d'amplification (2) utilise une pluralité d'unités d'amplification secondaires (10, 11, 12), où le procédé comprend la mise en fonctionnement de toutes les unités d'amplification secondaires (10, 11, 12) simultanément pendant la condition de chauffage.

14. Procédé selon l'une quelconque des revendications 11 ou 12, **caractérisé en ce qu'**au moins ladite première unité d'amplification (2) utilise une pluralité d'unités d'amplification secondaires (10, 11, 12), où le procédé comprend la mise en fonctionnement d'au moins deux unités d'amplification secondaires (10, 11, 12) séquentiellement pendant la condition de chauffage.
